# EUROPÄISCHE PATENTANMELDUNG

(11) **EP 2 061 071 A2**
(43) Veröffentlichungstag der Anmeldung: **20.05.2009**
(21) Anmeldenummer: 08018435.1
(22) Anmeldetag: 22.10.2008
(51) Int. Cl.: H01L 21/60, H01L 21/98, H01L 25/07

(54) **Verfahren zur Herstellung einer Halbleiterbaugruppe**

(30) Priorität: 16.11.2007 DE 102007054710
(71) Anmelder: SEMIKRON Elektronik GmbH & Co. KG, 90431 Nürnberg (DE)
(72) Erfinder: Stockmeier, Thomas Dr., 91054 Erlangen (DE); Heilbronner, Heinrich Dr., 90547 Stein (DE); Göbl, Christian, 90441 Nürnberg (DE)

(57) **Zusammenfassung**

Die Erfindung betrifft ein Verfahren zur Herstellung einer Halbleiterbaugruppe mit den wesentlichen Schritten: Ausbildung einer Anordnung mit mindestens einem Halbleiterbauelement, mit mindestens einer Anschlusseinrichtung und mit mindestens einem dazwischen angeordneten Verbindungsmittel; Vollständige oder teilweise Umhüllung der Anordnung; Ausbildung einer stoffschlüssigen Verbindung des mindestens einen Halbleiterbauelements und der mindestens einen Anschlusseinrichtung.

## Beschreibung

Die Erfindung beschreibt ein Herstellungsverfahren für eine Halbleiterbaugruppe, wie sie beispielhaft Teil eines Leistungshalbleitermoduls ist. Derartige Leistungshalbleitermodule weisen gemäß dem Stand der Technik ein Gehäuse, ein Substrat mit Leistungshalbleiterbauelementen, sowie Last- und Hilfsanschlusselemente auf. Unter einer Halbleiterbaugruppe soll im folgenden beispielhaft eine Baugruppe, als Teil eines Leistungshalbleitermoduls, aus einem Substrat und einem mit diesem stoffschlüssig verbundenen Halbleiterbauelement, oder eine aus einem Halbleiterbauelement und einem stoffschlüssig verbundenen Anschlusselement oder aus einer Kombination hiervon verstanden werden. Hierbei werden sowohl, aber nicht ausschließlich, Substrate wie auch Anschlusselemente unter dem Begriff Anschlusseinrichtung subsumiert.

Für die Herstellung derartiger Halbleiterbaugruppen sind gemäß dem Stand der Technik Löt- und Sinterverfahren bereits grundsätzlich bekannt. Die DE 199 11 887 C1 offenbart ein Reflow- Lötverfahren, charakterisiert durch eine zusätzliche Anordnung einer Vakuumeinrichtung. Hierbei wird nach dem eigentlichen Lötprozess in der Dampfphase das Lötgut in die Vakuumeinrichtung verbracht. Hierdurch wird die Lunkerbildung wirksam vermieden, da eventuelle Lunker mittels des Vakuums aus dem Lot entfernt werden.

Nachteilig an derartigen bekannten Lötverfahren ist beispielhaft, dass im Anschluss an das Löten der Halbleiterbaugruppe häufig ein Reinigungsschritt zur Entfernung von Flussmittelrückständen mittels einer Reinigungsflüssigkeit nachgeschaltet werden muss.

Die DE 10 2004 019 567 B3 offenbart eine aktuelle Weiterentwicklung des Drucksinterverfahrens charakterisiert durch ein spezielles Verfahren der Anordnung der Sinterpaste mittels eines Sprühauftrags auf eine Trägerfolie. Von dieser Trägerfolie wird in einem weiteren Schritt die vorgetrocknete Sinterpaste abgenommen und auf einer der zu verbindenden Oberflächen angeordnet. Als Sinterpaste für dieses Sinterverfahren wird eine an sich bekannte Mischung aus Silberpulver und einem Lösungsmittel wie beispielhaft Cyclohexanol verwendet.

Nachteilig an bekannten Sinterverfahren mittels mechanischer Pressen ist, dass sie häufig nur eine Sinterverbindung gleichzeitig herstellen können und / oder dass speziell bei der Verbindung von Halbleiterbauelementen die Gefahr des Bruchs desselben gegeben ist.

Eine moderne Ausgestaltung einer Anschlusseinrichtung für eine Halbleiterbaugruppe ist beispielhaft in der DE 10 2006 015 198 A1 offenbart. Eine derartige Anschlusseinrichtung ist hier ausgebildet als eine spezielle Ausgestaltung einer flexiblen Leiterplatte. Diese Ausgestaltung weist einen folienartigen Schichtaufbau aus einer abwechselnden Anordnung von leitenden und isolierenden Lagen auf.

Der Erfindung liegt die Aufgabe zugrunde bekannte Herstellungsverfahren für eine Halbleiterbaugruppe mit einer stoffschlüssigen Verbindung zwischen mindestens einem Halbleiterbauelement und mindestens einer Anschlusseinrichtung weiterzubilden, wobei die Verbindungspartner zumindest teilweise keinen direkten Kontakt zum Druck und /oder Temperatur eintragenden Medium aufweisen.

Diese Aufgabe wird erfindungsgemäß gelöst, durch ein Verfahren mit den Merkmalen des Anspruchs 1. Bevorzugte Ausführungsformen sind in den Unteransprüchen beschrieben.

Ausgangspunkt des erfindungsgemäßen Verfahrens zur Herstellung einer Halbleiterbaugruppe sind oben genannte Leistungshalbleitermodule. Halbleiterbaugruppen für derartige Leistungshalbleitermodule sollten eine Mehrzahl von Anforderungen erfüllen, die sich gemäß dem Stand der Technik zumindest teilweise gegenseitig ausschließen. Hierzu zählt die Ausbildung einer auch unter den üblichen Belastungen von Leistungshalbleitermodulen dauerhaft halt- und belastbaren stoffschlüssigen Verbindung zwischen Halbleiterbauelement und Anschlusseinrichtung. Andererseits zählt hierzu auch die kostengünstige und wenig zeitaufwendige Herstellung der Halbleiterbaugruppe.

Erfindungsgemäß weist das Herstellungsverfahren zur Ausbildung einer derartigen Halbleiterbaugruppe die folgenden wesentlichen Schritten auf:
A) Ausbildung einer Anordnung mit mindestens einem Halbleiterbauelement, mit mindestens einer Anschlusseinrichtung und mit mindestens einem dazwischen angeordneten Verbindungsmittel; vorzugsweise handelt es sich hierbei um die gleichzeitige Anordnung einer Mehrzahl von Leistungshalbleiterbauelementen auf einem Substrat. Hierbei ist beispielhaft mittels Siebdruck auf dem Substrat, genauer auf einer jeweiligen Anschlussfläche des Substrats, das Verbindungsmittel, vorzugsweise eine Lot- oder Sinterpaste, angeordnet und hierauf das jeweilig stoffschlüssig zu verbindende Leistungshalbleiterbauelement angeordnet.
B) In einem weiteren Schritt wird die gemäß Punkt A ausgebildete Anordnung reversibel und vollständig, vorzugsweise mittels einer Kunststofffolie, umhüllt; hierbei ist es besonders vorteilhaft die Anordnung in eine schlauchförmig ausgebildete Kunststofffolie einzubringen, diese zu evakuieren und zu verschließen. Somit bildet sich ein Schutz der Anordnung gegen weitere Herstellungsschritte aus. Eine weitere bevorzugte Ausführung der Umhüllung besteht aus einem gering viskosen Stoff, beispielhaft einem Silikonkautschuk, der die Anordnung nicht vollständig umhüllt.
C) Ausbildung einer stoffschlüssigen Verbindung des mindestens einen Halbleiterbauelements und der mindestens einen Anschlusseinrichtung; diese stoffschlüssige Verbindung ist vorzugsweise ausgebildet als eine Löt- oder Sinterverbindung. Hierbei ist es besonders bevorzugt den Temperatur- und / oder Druckeintrag auf die Anordnung mittels eines flüssigen Mediums auszuführen. Hierbei wirkt die Umhüllung als Schutzschicht gegen das flüssige Medium. Es wird somit sowohl eine Verunreinigung als auch ein mögliches Ausspülen des Verbindungsmittels verhindert. Gleichzeit behindert die Umhüllung den Temperatur- und / der Druckeintrag nur unwesentlich.
D) Bei Ausgestaltung als reversible Umhüllung wird diese anschließend entfernt. Hierdurch wird die Weiterverarbeitung der Halbleiterbaugruppe zu beispielhaft einem Leistungshalbleitermodul ohne weitere Verfahrensschritte, wie beispielhaft Reinigungsschritte, wie sie bei Lötverfahren häufig üblich sind, ermöglicht.

Das vorgestellte Verfahren zur Herstellung einer Halbleiterbaugruppe verbindet die Vorzüge der grundsätzlich bekannten stoffschlüssig Verbindungsverfahren mit der Möglichkeit diese mittels flüssiger Medien ausführen. Hierdurch können besonders bei Sinterverbindungen die Verzüge einer hydrostatischen Druckeinleitung im Gegensatz zu mechanischen Pressen ausgenützt werden. Einer diese Vorzüge ist vor allem eine allseitige gleichmäßige Druckeinleitung, die speziell die Bruchgefahr der Halbleiterbauelemente bei Druckbeaufschlagung verhindert oder zumindest deutlich reduziert.

Besonders bevorzugte Weiterbildungen dieses Herstellungsverfahrens sind in der jeweiligen Beschreibung der Ausführungsbeispiele genannt. Die erfinderische Lösung wird zudem an Hand der Ausführungsbeispiele der Fig. 1 bis 6 weiter erläutert.

Die Fig. 1 bis 3 zeigen drei wesentliche aufeinander folgende Schritte einer ersten Ausgestaltung des erfindungsgemäßen Herstellungsverfahrens einer Halbleiterbaugruppe.

Fig. 4 zeigt einen Verfahrensschritt einer zweiten Ausgestaltung des erfindungsgemäßen Herstellungsverfahrens.

Fig. 5 zeigt einen Verfahrensschritt einer dritten Ausgestaltung des erfindungsgemäßen Herstellungsverfahrens.

Fig. 6 zeigt einen Verfahrensschritt einer vierten Ausgestaltung des erfindungsgemäßen Herstellungsverfahrens.

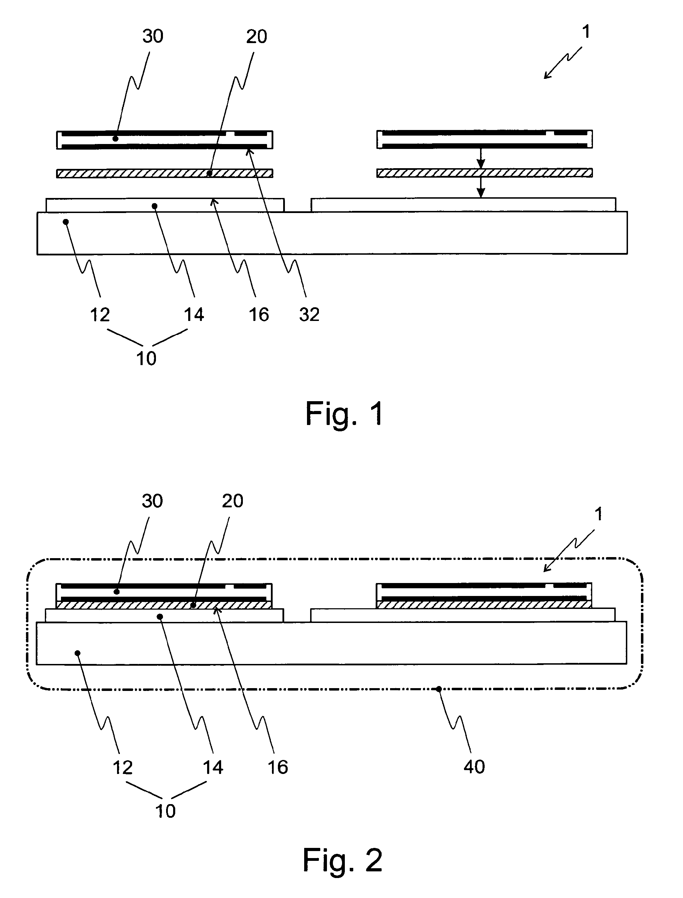

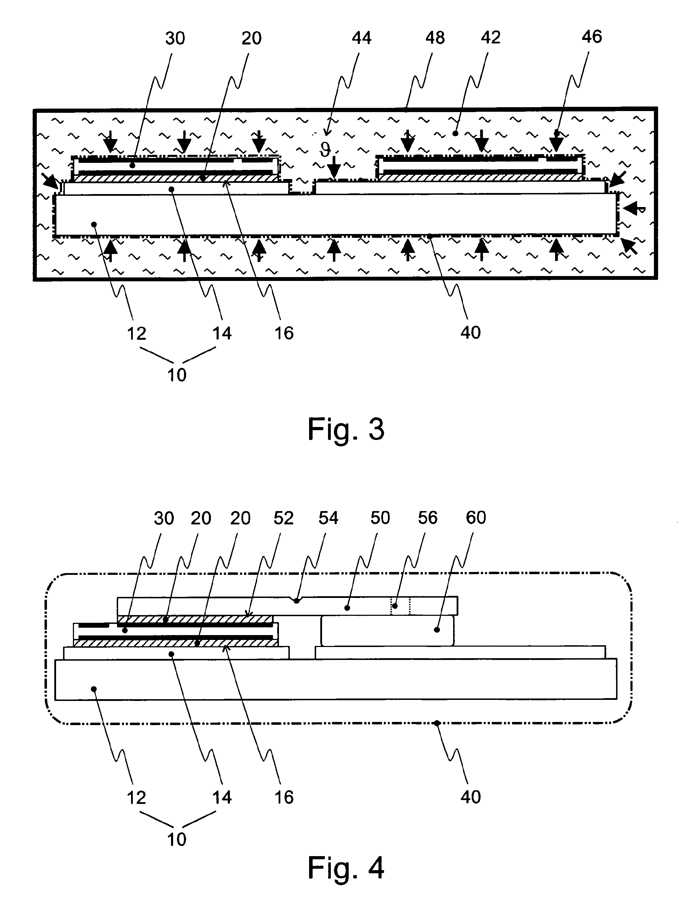

Fig. 1 zeigt einen ersten Schritt der erfindungsgemäßen Herstellung einer Halbleiterbaugruppe. Hierbei ist die Verbindungseinrichtung ausgestaltet als ein elektrisch isolierendes Substrat (10) mit einem Isolationsgrundkörper (12) und auf mindestens einer Hauptfläche angeordneten Mehrzahl von Leiterbahnen (14) und hierauf ausgebildeten Kontaktflächen (16) gemäß dem Stand der Technik. Bei Sinterverbindungen ist es gemäß dem Stand der Technik vorteilhaft, wenn diese Kontaktflächen (16) eine Edelmetalloberfläche aufweisen. Das Substrat (10) ist bevorzugt ausgebildet als konventionelle Leiterplatte, als IMS (insulated metall substrat) oder auch als DCB (direct copper bond) Substrat. Die beispielhafte Ausgestaltung der Anschlusseinrichtung als Substrat (10) soll allerdings nicht die oben genannte Allgemeinheit einschränken. Ebenso denkbar sind unter anderem auch Anschlusselemente (vgl. Fig. 4 is 6) zur Verbindung eines Substrats oder eines oder mehrerer Halbleiterbauelemente zur internen und / oder externen Kontaktierung.

Auf einer Kontaktfläche (16) auf einer Hauptfläche des Substrats (10) wird das Verbindungsmittel (20) hier eine Sinterpaste nach dem Stand der Technik angeordnet. Für Lotverbindungen wird hier selbstverständlich eine Lotpaste oder auch ein oder mehrere Lotplättchen angeordnet. Diese Lotplättchen bestehen aus einem Lotmaterial, das in seiner Form an die Größe des zu lötenden Halbleiterbauelements (30) angepasst ist und das als ein flächiger Metallkörper ausgebildet ist.

Die Anordnung einer Paste (20) ist dahingehend vorteilhaft, da diese einerseits am Substrat (10) haftet und andererseits ein hierauf anzuordnendes Halbleiterbauelement (30) ebenfalls anhaftet. Hierdurch sind meist keine weiteren Mittel zur Fixierung der Verbindungspartner (10, 30) zueinander notwendig. Es ist besonders vorteilhaft die jeweilige Paste (20) mittels eines Schablonendruckverfahrens auf den Kontaktflächen (16) der Hauptfläche des Substrats (10) anzuordnen. Hierbei kann in einem Arbeitsgang das Verbindungsmittel (20) für alle benötigten Einzelverbindungen aufgebracht werden. Eine Anordnung auf einer geeigneten Hauptfläche eines Halbleiterbauelements (30) kann in bestimmten Anwendungsfällen ebenfalls bevorzugt sein.

Die jeweiligen Halbleiterbauelemente (30) werden gemäß dem Stand der Technik im Pick- and- Place Verfahren direkt aus dem Waferverbund nach Vereinzelung auf dem Verbindungsmittel, der Sinterpaste (30), angeordnet.

Fig. 2 zeigt ein dem unter Fig. 1 beschriebenen nachfolgenden Verfahrensschritt. Hierbei wird die Anordnung (1) aus einer Mehrzahl von Halbleiterbauelementen (30), einem Substrat (10) und jeweils geeignet dazwischen aufgebrachter Sinterpaste (20) mit einem Kunststoff in Form einer Folie (40) umhüllt. Für die im Sinterverfahren nachfolgende Druckbeaufschlagung muss diese Folie (40) die Anordnung (1) vollständig umhüllen.

Hierzu bietet sich die Möglichkeit der Verwendung eines Kunststoffes in Ausgestaltung eines Schrumpfschlauches an. Die Anordnung (1) wird hierzu in den Schrumpfschlauch (40) verbracht, annähernd vollständig verschlossen und anschließend derart mit Temperatur beaufschlagt, dass er sich der Schrumpfschlauch (40) an die Kontur der Anordnung anpasst (vgl. Fig. 3). Anschließend wird der Schrumpfschlauch (40) vollständig verschlossen.

Eine weitere nicht beschränkende Möglichkeit besteht ebenfalls in der Verwendung einer schlauchfömig ausgebildeten elastischen Kunststofffolie, in die die Anordnung eingebracht wird. Der Schlauch wird annähernd vollständig verschlossen und evakuiert. Nachdem der Schlauch im Anschluss vollständig verschlossen wurde, ist die Anordnung bereit zur weiteren Bearbeitung im nachfolgenden Verfahrensschritt.

Fig. 3 zeigt den anschließenden Verfahrensschritt der Ausbildung der stoffschlüssigen Verbindung, hier der Sinterverbindung. Hierzu wird die mit der Kunststofffolie (40) umhüllte Anordnung (1) mit einem Druck (46) in der Größenordnung von 100MPa und mit einer Temperatur (44) in der Größenordnung von 100°C beaufschlagt. Hierbei ist es besonders vorteilhaft die umhüllte Anordnung (40) in einen mit einem druckstabilen Silikonöl (42) befüllten Drucktank (48) zu verbringen und dort für einen geeigneten Zeitraum mit Druck (46) zu beaufschlagen. Diese hydrostatische Druckeinleitung (46) führt zu einer besonders materialschonenden Druckbeaufschlagung der Verbindungspartner (10, 30).

Für die Ausbildung einer Lotverbindung wird eine analog vorbereitete mit Kunststofffolie umhüllte Anordnung in eine auf Lottemperatur erhitze Flüssigkeit eingebracht. Hierzu eigenen sich besonders Flüssigkeiten, wie sie auch für die Verwendung in Dampfphasenlötanlagen bekannt sind.

Fig. 4 zeigt einen Verfahrensschritt einer zweiten Ausgestaltung des erfindungsgemäßen Herstellungsverfahrens. Hierbei handelt es sich um einen Verfahrensschritt vergleichbar demjenigen unter Fig. 2. Im Unterschied hierzu ist hier die Vorbereitung für die Lötverbindungen eines Leistungshalbleiterbauelements (30) mit einer Leiterbahn (14) eines Substrat (10) und gleichzeitig mit einem Lastanschlusselement in Gestalt eines Metallformkörpers (50) dargestellt.

Das Lastanschlusselement (50) weist eine Kontaktfläche (52) zu einer Lotpaste (20), die auf einem Halbleiterbauelement (30) angeordnet ist, auf. Weiterhin weist es eine als Biegekante dienende Prägung (54) sowie eine Ausnehmung (56) zur externen Kontaktierung auf. Zur Lagefixierung und -kontrolle ist im Bereich der Ausnehmung zwischen dem Lastanschlusselement (50) und dem Substrat (10) ein Positionierhilfskörper (60) angeordnet. Nach der Anordnung der Umhüllung (40) kann im Anschluss die Lotverbindung mittels einer geeigneten Flüssigkeit erfolgen.

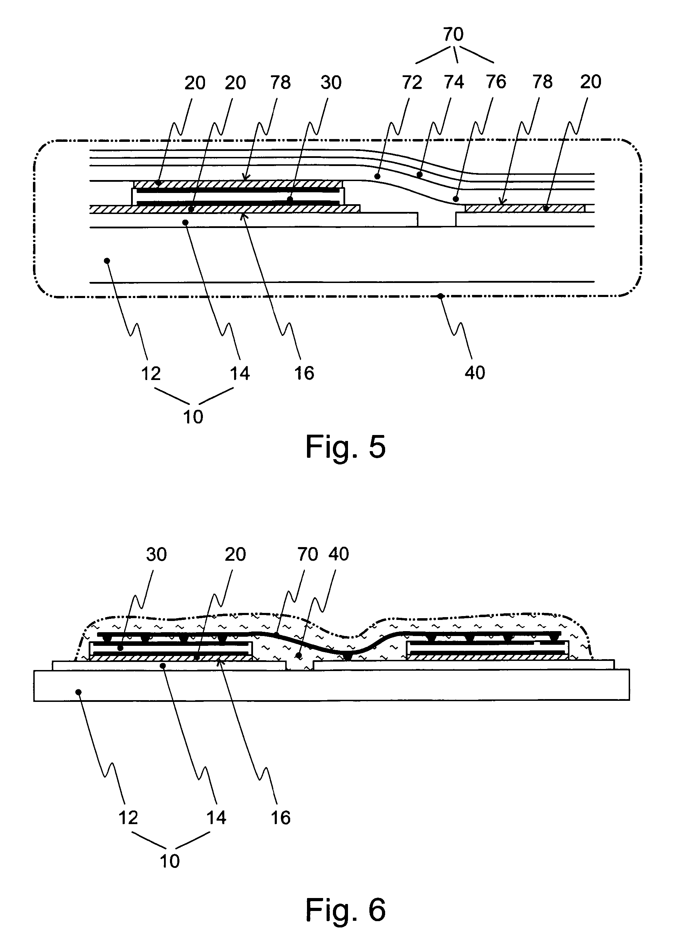

Fig. 5 zeigt einen Verfahrensschritt einer dritten Ausgestaltung des erfindungsgemäßen Herstellungsverfahrens. Hierbei handelt es sich wiederum um einen Verfahrensschritt vergleichbar demjenigen unter Fig. 2. Im Unterschied hierzu ist die Anschlusseinrichtung ausgebildet als eine flexible Leiterplatte (70). Gemäß dem Stand der Technik ist bekannt diese beispielhaft als eine Schichtfolge aus jeweils einer leitenden (72, 76) und einer isolierenden (74) Schicht, hier dargestellt im Dreischichtaufbau, auszugestalten. Es ist ebenso bekannt zwischen den leitenden Schichten (72, 76) schaltungsgerechte Durchkontaktierungen vorzusehen.

Besonders vorteilhaft an der Verwendung einer flexiblen Leiterplatte (70) ist hier, dass in einem Verfahrensschritt sowohl das Leistungshalbleiterbauelement (30) mit einer ersten Leiterbahn (14) des Substrats (10) als auch mit der flexiblen Leiterplatte (70) und ebenfalls die flexible Leiterplatte (70) mit einer weiteren Leiterbahn (14) des Substrats (10) verbunden werden kann. Für derartige Ausgestaltungen der Halbleiterbaugruppe ist es besonders bevorzugt als jeweiliges Verbindungsmittel eine Sinterpaste (20) vorzusehen und die Verbindungen mittels des oben bereits beschrieben Drucksinterverfahrens auszuführen. Es ist hierbei selbstverständlich die Oberflächen (16) der Leiterbahn (14) des Substrats (10), die Kontaktflächen des Halbleiterbauelements (30) und die Kontaktflächen (78) der zu verbindenden leitenden Schicht (72) der flexiblen Leiterplatte (70) mit einem geeigneten Material, vorzugsweise einem Edelmetall, zu versehen.

Fig. 6 zeigt einen Verfahrensschritt einer vierten Ausgestaltung des erfindungsgemäßen Herstellungsverfahrens. Hierbei handelt es sich wiederum um einen Verfahrensschritt vergleichbar demjenigen unter Fig. 2. Vergleichbar mit Fig. 5 ist die Anschlusseinrichtung wiederum ausgebildet als eine Variante einer flexiblen Leiterplatte (70) mit Kontaktwarzen zur elektrischen Verbindung zu den Leistungshalbleiterbauelementen (30) bzw. zu Anschlussflächen (14) des Substrats.

Besonders vorteilhaft an dieser Ausgestaltung des erfindungsgemäßen Verfahrens ist hier, dass als Umhüllung (40) ein Silikonkautschuk angeordnet ist wie er als Isolationsstoff in Leistungshalbleitermodulen seit langem Stand der Technik ist. Dieser Silikonkautschuk (40) dient einerseits auch in dieser Anwendung der Isolation des später herzustellenden Leistungshalbleitermoduls und andererseits während des Drucksinterverfahrens als schützende, hier nur teilweise ausgebildete Umhüllung (40) der Anordnung (1). Durch die Druckbeaufschlagung in einem Drucktank (48) erfolgt die Druckeinleitung hydrostatisch auf den Silikonkautschuk (40), der diesen Druck auf die zu verbindende Teile der Anordung (1) weiterleitet ohne selbst seine Position signifikant zu verändern.

## Patentansprüche

1. Verfahren zur Herstellung einer Halbleiterbaugruppe mit den wesentlichen Schritten:
A) Ausbildung einer Anordnung (1) mit mindestens einem Halbleiterbauelement (30), mit mindestens einer Anschlusseinrichtung (10, 50, 70) und mit mindestens einem dazwischen angeordneten Verbindungsmittel (20);
B) Vollständige oder teilweise Umhüllung (40) der Anordnung (1);
C) Ausbildung einer stoffschlüssigen Verbindung des mindestens einen Halbleiterbauelements (30) und der mindestens einen Anschlusseinrichtung (10, 50).

2. Verfahren nach Anspruch 1,
wobei das Verbindungsmittel (20) als ein Lotplättchen oder eine Lotpaste ausgebildet ist und diese mittels Schablonendrucktechnik auf einer Hauptfläche (16, 32) des Halbleiterbauelements (30) oder der Anschlusseinrichtung (10, 50) aufgebracht ist.

3. Verfahren nach Anspruch 1,
wobei das Verbindungsmittel (20) als eine Sinterpaste ausgebildet ist und diese mittels Schablonendrucktechnik auf einer Hauptfläche (16, 32) des Halbleiterbauelements (30) oder der Anschlusseinrichtung (10, 50, 70) aufgebracht ist.

4. Verfahren nach Anspruch 1,
wobei im Anschluss an die Ausbildung der Verbindung die Umhüllung (40) wieder von der Anordnung (1) entfernt wird

5. Verfahren nach Anspruch 1,
wobei die Anschlusseinrichtung ein Substrat (10) und / oder ein Anschlusselement in Ausgestaltung eines Metallformkörpers (50) eines Leistungshalbleitermoduls (30) ist.

6. Verfahren nach Anspruch 1,
wobei die Anschlusseinrichtung eine flexible Leiterplatte (70) mit einen Schichtaufbau aus leitenden (72, 76) und isolierenden (74) Lagen ist.

7. Verfahren nach Anspruch 1,
wobei die Umhüllung (40) als schlauchförmige Folie ausgebildet ist, die nach der Umhüllung verschlossen und anschließend evakuiert, oder durch Temperaturbeaufschlagung geschrumpft wird, damit sie an der Anordnung anliegt.

8. Verfahren nach Anspruch 1,
wobei die Umhüllung (40) ausgebildet ist mittels eines gering viskosen Stoffes.

9. Verfahren nach Anspruch 1 und 2,
wobei die Ausbildung der stoffschlüssigen Verbindung mittels einer auf Lottemperatur erhitzten Flüssigkeit (42) erfolgt, und hierzu die Anordnung (1) zeitweise in diese Flüssigkeit (42) verbracht wird.

10. Verfahren nach Anspruch 1 und 3,
wobei die Ausbildung der stoffschlüssigen Verbindung mittels einer in einem Drucktank (48) befindlichen Flüssigkeit (42), einem druckstabilen Silikonöl, erfolgt und hierzu die Anordnung (1) zeitweise in diese Flüssigkeit (42) verbracht wird und die Flüssigkeit (42) anschließend von außen mit Druck (46) beaufschlagt wird.
